# EUROPEAN PATENT APPLICATION

(11) **EP 4 455 826 A1**
(43) Date of publication of application: **30.10.2024**
(21) Application number: 22909915.5
(22) Date of filing: 19.12.2022
(51) Int. Cl.: G05D 23/22, H01L 21/67

(54) **PIPELINE TEMPERATURE CONTROL DEVICE AND PIPELINE TEMPERATURE CONTROL METHOD**

(30) Priority: 21.12.2021 CN 202111570560
(71) Applicant: Beijing NAURA Microelectronics Equipment Co., Ltd., Beijing 100176 (CN)
(72) Inventor: HU, Caifeng, Beijing 100176 (CN)
(74) Representative: Cohausz & Florack
(86) International application number: PCT/CN2022/139907
(87) International publication number: WO 2023/116602

(57) **Abstract**

The present disclosure provides a pipeline temperature control equipment and a pipeline temperature control method, which are used in a semiconductor equipment. The pipeline temperature control equipment includes a processing device and multiple heating assemblies distributed along an extension direction of the temperature-controlled pipeline. Each heating assembly includes a heating device, a first temperature measuring device, a second temperature measuring device, and a control device. The first temperature measuring device and the second temperature measuring device in each heating assembly are used to measure a real-time temperature of the temperature-controlled pipeline, and are all connected to the control device in the heating assembly. Multiple control devices are connected to the processing device, and the processing device can, based on a measured value of the first temperature measuring device or the second temperature measuring device in each heating assembly, through the multiple control devices, control the multiple heating devices to work respectively until the multiple heated parts meet their respective target temperatures. The above technical solution can address the issue that the failure of the temperature control thermocouple will cause the process to be terminated and the wafer to be scrapped, which will have a great adverse impact on the continuity of the process.

## Description

### TECHNICAL FIELD

The present disclosure generally relates to the field of semiconductor processing technology and, more particularly, relates to a pipeline temperature control device and pipeline temperature control method.

### BACKGROUND

In the process of semiconductor fabrication, it is usually necessary to perform multiple processes on wafers. Some of these processes require the introduction of specific process gases through pipelines. In order to ensure relatively optimal process outcomes, the temperature of the process gas needs to be controlled during the process of introducing the process gas. Currently, it is common to employ heating devices installed on pipelines to heat the process gases transported into process chambers. These heating devices are equipped with temperature control thermocouples, which regulate the heating of the heating devices based on feedbacks of temperatures measured by the thermocouples. This ensures that the pipelines and the process gases they transport meet target temperatures. However, during the operation of the aforementioned technical solution, any malfunction of the temperature control thermocouples can result in heating failure, leading to process interruption, wafer scrap, and significant adverse effects on the continuity of the process.

### SUMMARY

The present disclosure provides a pipeline temperature control equipment and method thereof, which addresses the issue of process interruption and wafer scrap caused by the failure of temperature control thermocouples and a subsequent issue of a great adverse impact on the continuity of the process.

To address the aforementioned issues, embodiments of the present disclosure are implemented as follows:

One aspect of embodiments of the present disclosure provides a pipeline temperature control equipment for semiconductor equipment, including a processing device and multiple heating assemblies. The multiple heating assembles are distributed along an extension direction of the temperature-controlled pipeline to correspondingly control the temperatures of multiple heated parts of the temperature-controlled pipeline. Each heating assembly includes a heating device, a first temperature measuring device, a second temperature measuring device, and a control device.

Both the first temperature measuring device and the second temperature measuring device in each heating assembly are used to measure a real-time temperature of the heated parts of the temperature-controlled pipeline corresponding to the heating device in the heating assembly. Both the first temperature measuring device and the second temperature measuring device in each heating assembly are connected to the control device in the heating assembly; multiple control devices are all connected to the processing device;

The processing device is configured to, according to respective target temperatures of multiple heated parts of the temperature-controlled pipeline and measured values of the respective first temperature measuring devices of the multiple heating assemblies, control operations of multiple heating devices through multiple control devices, respectively, until temperatures of the multiple heated parts meet their respective target temperatures;

The processing device is further configured to, when the measured values from the first temperature measuring device within a preset time period are abnormal, according to the measured value of the corresponding second temperature measuring device and the target temperature of the corresponding heated part, control the corresponding heating device to heat the heated parts through the corresponding control device;

The processing device is further configured to, when both the first temperature measuring device and the second temperature measuring device in any of the heating assemblies within their respective preset time periods have abnormal measured values, through controlling the corresponding heating device to follow a heating state of the heating device of an adjacent heated part using the corresponding control device, heat the heated part.

Another aspect of embodiments of the present disclosure provides a pipeline temperature control method, applied to the pipeline temperature control equipment. The pipeline temperature control method includes:
S1: Receiving a temperature control command;
S2: According to the respective target temperatures of the multiple heated parts of the controlled-temperature pipeline and the measured values of the respective first temperature measuring devices of the multiple heating assemblies, through the multiple control devices, respectively controlling operations of the multiple heating devices, until the multiple heated parts meet their respective target temperatures;
S3: When the measured value of the first temperature measuring device within a preset time period become abnormal, according to the measured value of the corresponding second temperature measuring device and the target temperature of the corresponding heated part, through the corresponding control device, controlling the corresponding heating device to heat the corresponding heated part;
S4: When the measured values from both the first temperature measuring device and second temperature measuring device in any heating assemblies become abnormal within their respective preset time periods, through the corresponding control device, controlling the corresponding heating device to follow the heating state of heating device in the adjacent heated part to heat the corresponding heated part.

Embodiments of the present disclosure provide a pipeline temperature control equipment and a method thereof. The pipeline temperature control equipment includes a processing unit and multiple heating assemblies. The multiple heating assemblies are distributed along the extension direction of the temperature-controlled pipeline, allowing the pipeline temperature control equipment heat and temperature control the temperature-controlled pipeline from multiple positions of the temperature-controlled pipeline simultaneously. Moreover, each of the multiple heating assemblies includes a control device, a first temperature measuring device, a second temperature measuring device, and a heating device. Both the first temperature measuring device and the second temperature measuring device in each heating assembly can measure the temperature of the corresponding position on the temperature-controlled pipeline. Each first temperature measuring device and each second temperature measuring device can transmit the measured values to the processing unit through the control device, enabling accurate assessment of the measured values of the respective first temperature measuring device and the second temperature measuring device in each heating assembly.

Furthermore, when the measured value of the first temperature measuring device in any heating assembly remains normal, that is, the measured value of the first temperature measuring device is used as the real-time temperature of the heated part corresponding to the first temperature measuring device in the temperature-controlled pipeline. However, when the measured value of the first temperature measuring device in any heating assembly becomes abnormal and the measured value of the second temperature measuring device in the same heating assembly remains normal, the measured value of the second temperature measuring device of the heating assembly is used as the real-time temperature of the heated part corresponding to the first temperature measuring device in the temperature-controlled pipeline. Based on the target temperature of the heated part in the temperature-controlled pipeline corresponding to the heating assembly and the measured value of the real-time temperature of the heated part of the first temperature measuring device or second temperature measuring device, the processing device can control the operation of the corresponding heating device through the control device corresponding to heat the heated part to reach the target temperature.

Moreover, when the measured values of both the first temperature measuring device and second temperature measuring device in any heating assembly become abnormal, the heating state of the heating device in an adjacent heating assembly to the heating assembly can be utilized. This allows the processing device to control the heating device in the temperature-controlled pipeline corresponding to the heated part with abnormal temperature measurement through the control device to heat the heated part, making the temperature of the heated part as close as possible to or equal to its target temperature.

By employing the above technical solutions, even if any first temperature measuring device and/or any second temperature measuring device in the pipeline temperature control equipment fails, the heating operation of the temperature-controlled pipeline can continue normally without causing process interruption. This enhances the yield of wafers and ensures the continuity of the process.

Furthermore, as described above, the multiple heating assemblies are distributed along the extension direction of the temperature-controlled pipeline, and under the joint influence of the multiple heating assemblies, multiple positions on the temperature-controlled pipeline can be heated separately. By pre-heating the process gas and increasing the length of the heated part in the process gas transmission path, it ensures the temperature of the process gas transported in the temperature-controlled pipeline can be closer to the preset temperature when transported to the process chamber, thereby improving process effect.

### BRIEF DESCRIPTION OF THE DRAWINGS

The accompanying drawings provided herein are intended to facilitate a better understanding of the present disclosure and constitute a part thereof. The illustrative embodiments and their explanations in the present disclosure are for the purpose of elucidating the present disclosure and do not constitute improper limitation thereof. In the drawings:
FIG. 1 illustrates a schematic diagram of the structure of a pipeline temperature control equipment disclosed in embodiments of the present disclosure;
FIG. 2 illustrates a flow chart of a pipeline temperature control method disclosed in embodiments of the present disclosure;
FIG. 3 and FIG. 4 illustrate schematic diagrams of the distribution of measured values of the first temperature measuring device and the second temperature measuring device in the pipeline temperature control equipment disclosed in embodiments of the present disclosure;
FIG. 5 illustrates a schematic diagram of the distribution of measured values when a temperature measuring device disconnects in the pipeline temperature control equipment disclosed in embodiments of the present disclosure;
FIG. 6 illustrates a schematic diagram of the distribution of measured values when a temperature measuring device has a jump change in the pipeline temperature control equipment disclosed in embodiments of the present disclosure;
FIG. 7 illustrates a schematic flow chart of the pipeline temperature control method disclosed in embodiments of the present disclosure;
FIG. 8 illustrates a schematic diagram of partial flow chart in the pipeline temperature control method disclosed in embodiments of the present disclosure.

### Reference symbols:

100-processing device,
200-heating assembly, 210-heating device, 220-first temperature measuring device, 230-second temperature measuring device, 240-control device.

### DETAILED DESCRIPTION

In order to better describe the technical solution, objectives, and advantages of the present disclosure, specific embodiments and corresponding drawings will be described in detail below. It is apparent that the described embodiments are only part of the embodiments of the present disclosure, not all embodiments. Based on the embodiments disclosed herein, all other embodiments obtained by those persons of ordinary skill in the art without inventive labor are within the scope of protection of the present disclosure.

Detailed descriptions of the technical solutions disclosed in various embodiments of the present disclosure are provided below in conjunction with the accompanying drawings.

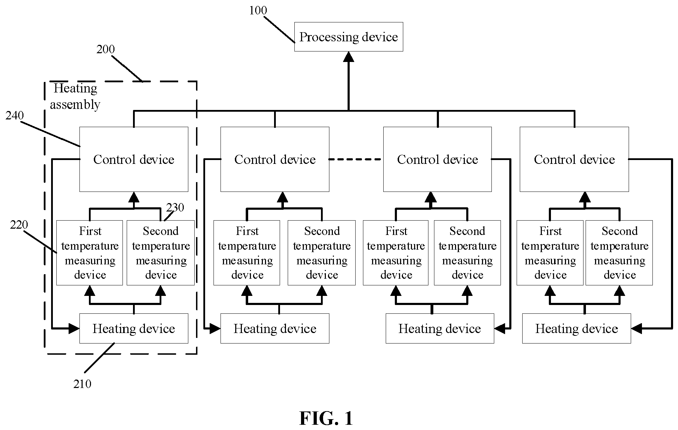

As shown in FIG. 1, embodiments of the present disclosure provide a pipeline temperature control device. The pipeline temperature control equipment can be used to control the temperature of a temperature-controlled pipeline used for transporting process gas, thereby controlling the temperature of the process gas transported in the temperature-controlled pipeline. The pipeline temperature control equipment includes a processing device 100 and multiple heating assemblies 200.

In some embodiments, the processing device 100 is a device used to provide data processing and overall control in the pipeline temperature control equipment. By pre-inputting relevant algorithms and temperature control data into the processing device 100, the processing device 100 can control the operation of the multiple heating assemblies 200 separately based on the relevant algorithms and temperature control data, together with measured temperatures at different positions on the temperature-controlled pipeline, achieving that temperatures of corresponding parts of the temperature-controlled pipeline can respectively meet their corresponding target temperatures.

The multiple heating assemblies 200 are distributed along the extension direction of the temperature-controlled pipeline, so that under the influence of the multiple heating assemblies 200, the temperatures of multiple heated parts of the temperature-controlled pipeline can be controlled accordingly. In other words, the multiple heating assemblies 200 are used to control the temperature of multiple heated parts of the temperature-controlled pipeline respectively, so that the temperatures of the multiple heated parts of the temperature-controlled pipeline can respectively meet their target temperatures.

Each heating assembly 200 includes a heating device 210, a first temperature measuring device 220, a second temperature measuring device 230, and a control device 240. The heating device 210 is a device in the heating assembly 200 used to provide heating, which can specifically be an electric heating device such as a resistive element. The first temperature measuring device 220 and the second temperature measuring device 230 in each heating assembly 200 are arranged in groups, and each is capable of measuring the real-time temperature of the heated part in the temperature-controlled pipeline corresponding to the heating device 210 in the heating assembly 200. Specifically, for each heating assembly 200, the corresponding positions of the heating device 210, the first temperature measuring device 220, and the second temperature measuring device 230 in the temperature-controlled pipeline are identical to ensure that the heating assembly 200 can accordingly control the parameters such as the heating power and the heating time of the heating device 210 based on the measured temperatures at the position in the temperature-controlled pipeline.

Specifically, the first temperature measuring device 220 and the second temperature measuring device 230 can be an infrared temperature sensor, a laser temperature sensor, a thermocouple, etc., and the control device 240 can be a device with a control function such as a switch. The control device 240 can also include a variable resistor to ensure that the control device 240 can adjust the heating power of the heating device 210 and the like.

In the heating assembly 200, both the first temperature measuring device 220 and the second temperature measuring device 230 of each heating assembly 200 are connected to the control device 240 in a same heating assembly 200, thereby ensuring that the measured values of the first temperature measuring device 220 and the second temperature measuring device 230 can be transmitted to the control device 240. The measured values of the first temperature measuring device 220 and the second temperature measuring device 230 are respectively denoted as TCn-C and TCn-M. Since both are temperature measuring devices, their measured values can be collectively referred to as TCn-*.

Moreover, the multiple control devices 240 are connected to the processing device 100, enabling the respective measured values of the first temperature measuring device 220 and the second temperature measuring device 230 of the multiple heating assemblies 200 to be transmitted to the processing device 100 via the control device 240. This allows the processing device 100 to obtain the real-time temperatures of multiple parts in the temperature-controlled pipeline corresponding to multiple first temperature measuring devices 220 and multiple second temperature measuring devices 230.

As described above, relevant algorithms and parameters such as the target temperatures of multiple heated parts in the temperature-controlled pipeline can be pre-inputted into processing device 100. This allows the processing device 100, based on the respective target temperatures of the multiple heated parts of the temperature-controlled pipeline as well as the measured temperatures of the multiple parts in the temperature-controlled pipeline by the first temperature measuring device 220 in each of the multiple heating assemblies 200, through multiple control devices 240, respectively control the operation of the multiple heating devices 210, until the temperatures of the multiple heated parts of the multiple temperature-controlled pipelines respectively meet their target temperatures.

Of course, the processing device 100 can also assess the accuracy of the measured values of the first temperature measuring devices 220 of each of the multiple heating assemblies 200. In the event of an anomaly in the measured values of any one first temperature measuring device 220 within a preset time period, the processing device 100 can, based on measured values of the second temperature measuring device 230 corresponding to the first temperature measuring device 220 experiencing the measurement anomaly as well as the target temperature of the heated part in the temperature-controlled pipeline corresponding to the first temperature measuring device 220 experiencing the measurement anomaly, through the control device 240 corresponding to the first temperature measuring device 220 experiencing the measurement anomaly, control the heating device 210 corresponding to first temperature measuring device 220 experiencing the measurement anomaly to heat the heated part. This ensures that the temperature of the heated part in the temperature-controlled pipeline reach its target temperature.

In addition, the processing device 100 can also assess the accuracy of the measured values of the second temperature measuring device 230 of each heating assembly 200. In the event of anomalies in the measured values of both the first temperature measuring device 220 and the second temperature measuring device 230 within respective preset time periods in any one heating assembly 200, the processing device 100 can, through the control device 240 corresponding to the (first temperature measuring device 220 and) the second temperature measuring device 230 experiencing the measurement anomaly, control the heating device 210 corresponding to the (first temperature measuring device 220 and) the second temperature measuring device 230 experiencing the measurement anomaly. The processing device 100 adopts a method of following the heating state of the heating device 210 of a different heated part adjacent to the heated part corresponding to the (first temperature measuring device 220 and) the second temperature measuring device 230 experiencing the measurement anomaly in the temperature-controlled pipeline, to heat the heated parts in the temperature-controlled pipeline corresponding to the (first temperature measuring device 220 and) the second temperature measuring device 230 experiencing the measurement anomaly. Therefore, the temperature of the heated parts in the temperature-controlled pipeline corresponding to the (first temperature measuring device 220 and) the second temperature measuring device 230 with abnormal measurement data can be close to, or meet the target temperatures of the heated parts.

It should be noted that the target temperature of each heated part of the temperature-controlled pipeline can be flexibly determined based on the material of the temperature-controlled pipeline, as well as parameters such as the specific type and flow rate of the medium being transported, without limitation here. Correspondingly, the aforementioned algorithm can be determined based on the heating power of the respective heating device 210 of each heating assembly 200, the material and size of the temperature-controlled pipeline, and parameters such as the specific heat capacity and flow rate of the transported medium. In other words, based on the real-time temperature and target temperature of the medium to be transported, the required heat can be obtained, thereby determining the output power and heating time of the heating device 210. This ensures that the heating device 210 can heat the transported medium from the real-time temperature to the target temperature using the aforementioned output power and heating time.

Additionally, during the operation of the pipeline temperature control equipment, feedback regulation can be utilized by intermittently measuring the real-time temperature of the temperature-controlled pipeline and adjusting the heating parameters of each heating assembly 200 based on the aforementioned related algorithms. This can maximize the assurance that the temperature of the temperature-controlled pipeline can better meet its target temperature, thereby improving the process results.

Embodiments of the present disclosure demonstrate a pipeline temperature control equipment and a pipeline temperature control method. The pipeline temperature control equipment includes a processing device 100 and multiple heating assemblies 200. Multiple heating assemblies 200 are distributed along the extension direction of the temperature-controlled pipeline, enabling the pipeline temperature control equipment can simultaneously perform heating and temperature control operations on the temperature-controlled pipeline at multiple positions on the temperature-controlled pipeline. Furthermore, each heating assembly 200 includes a control device 240, a first temperature measuring device 220, a second temperature measuring device 230, and a heating device 210. Both the first temperature measuring device 220 and the second temperature measuring device 230 in each heating assembly 200 can measure the temperature at the corresponding position on the temperature-controlled pipeline. Each first temperature measuring device 220 and each second temperature measuring device 230 can send the measured data to the processing device 100 via the control device 240, enabling the processing device 100 to assess the accuracy of the measured values of the first temperature measuring device 220 and the second temperature measuring device 230 in each heating assembly 200 respectively.

Moreover, in the absence of anomalies in the measured values of the first temperature measuring device 220 in each heating assembly 200, that is the measured value of the first temperature measuring device 220 is utilized as the real-time temperature of the heated parts in the temperature-controlled pipeline corresponding to the first temperature measuring device 220. When the measured values of the first temperature measuring device 220 in any one heating assembly 200 are abnormal and the measured values of the second temperature measuring device 230 of the heating assembly 200 are normal, the measured values of the second temperature measuring device 230 of the heating assembly 200 are utilized as the real-time temperature of the heated parts in the temperature-controlled pipeline corresponding to the first temperature measuring device 220. Based on the target temperature of the heated part in the temperature-pipeline controlled corresponding to the heating assembly 200, and the measured values of the real-time temperatures of the heated parts of the first temperature measuring device 220 or the second temperature measuring device 230, the process device 100 can control the operation of the corresponding heating device 210 through the control device 240 corresponding to the heated parts, thereby heating the heated parts to the target temperature.

Additionally, in the event of anomalies in the measured values of both the first temperature measuring device 220 and the second temperature measuring device 230 within their respective preset time periods in any one heating assembly 200, the heating state of the heating device 210 in an adjacent heating assembly 200 can be utilized to allow the processing device 100 to control the heating device 210 in the temperature-controlled pipeline corresponding to the heated part with abnormal temperature measurement through the control device 240 to heat the heated parts. This ensures that the temperature of the heated parts can be brought as close as possible to or even equal to their target temperatures.

By implementing the above technical solutions, even if any first temperature measuring device 220 and/or any second temperature measuring device 230 in the pipeline temperature control equipment fails, the heating operation of the temperature-controlled pipeline can be continued and proceed normally, preventing the termination of the process and thereby improving the yield of the wafers and ensuring good continuity of the process.

Furthermore, as described above, multiple heating assemblies 200 are distributed along the extension direction of the temperature-controlled pipeline, allowing heating operations to be conducted respectively at multiple positions on the temperature-controlled pipeline under the joint action of the multiple heating assemblies 200. By preheating the process gas and increasing the length of the heated part in the process gas transmission path, it ensures that the temperature of the process gas transported in the temperature-controlled pipeline can be closer to the preset temperature when transported to the process chamber to improve the process effect.

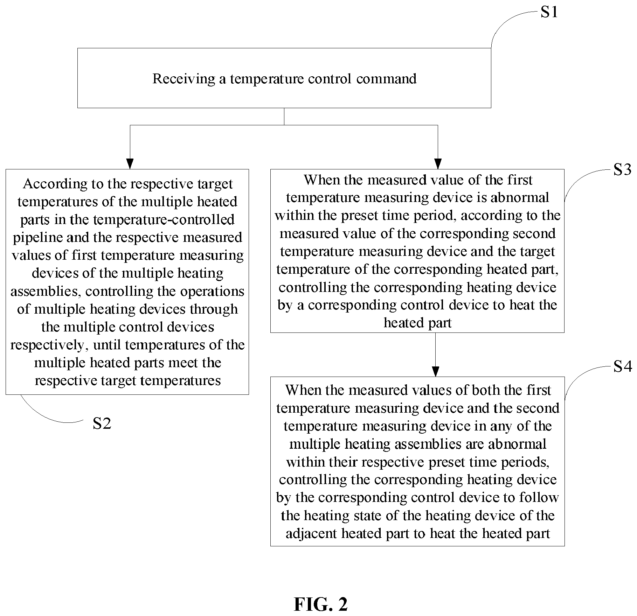

As shown in FIG. 2, embodiments of the present disclosure also demonstrate a pipeline temperature control method, applied to the pipeline temperature control equipment provided in the above embodiment. The pipeline temperature control method may include the following steps.

S1: Receiving a temperature control command.

In some embodiments, the temperature control command can be specifically issued by the processing device and transmitted to multiple control devices, which then send the temperature control command to the corresponding heating device. The temperature control command is used to direct the heating of corresponding heated parts in the temperature-controlled pipeline, so that the temperatures of multiple corresponding heated parts in the temperature-controlled pipeline can respectively meet their target temperatures.

S2: According to the respective target temperatures of the multiple heated parts of the controlled-temperature pipeline and the measured values of the respective first temperature measuring devices of the multiple heating assemblies, through the multiple control devices, respectively controlling operations of the multiple heating devices, until the multiple heated parts meet their respective target temperatures;
Specifically, the respective first temperature measuring devices in multiple heating assemblies can be used to measure the temperatures of the corresponding parts of the temperature-controlled pipeline, so that the measured values of the multiple first temperature measuring devices can be used as the actual temperatures of corresponding multiple heated parts in the temperature-controlled pipeline. After receiving the temperature control command, the operations of multiple heating devices are respectively controlled by multiple control devices according to respective target temperatures of the multiple heated parts on the temperature-controlled pipeline and the measured values of the respective first temperature measuring devices of the multiple heating assemblies, until the temperatures of multiple heated parts respectively meet their target temperatures.

Of course, due to the possibility of inaccurate measured values of the first temperature measuring device, the pipeline temperature control method provided in the present disclosure also includes:
S3: When the measured value of the first temperature measuring device within a preset time period become abnormal, according to the measured value of the corresponding second temperature measuring device and the target temperature of the corresponding heated part, through the corresponding control device, controlling the corresponding heating device to heat the corresponding heated part;

In other words, if the measured values of any first temperature measuring device within a preset time period are anomalous, it is impossible to continue to use the measured values of the first temperature measuring device as the actual temperature of the heated part corresponding to the first temperature measuring device in the temperature-controlled pipeline. Therefore, other methods are required to obtain the actual temperature of the heated parts corresponding to the first temperature measuring device in the temperature-controlled pipeline. Furthermore, as described above, in the pipeline temperature control equipment, the second temperature measuring device of each heating assembly can also measure the temperature of the corresponding heated parts in the temperature-controlled pipeline. Thus, in the event of anomalies in the measured values of any first temperature measuring device, through the measured values of the second temperature measuring device corresponding to the first temperature measuring device as well as the target temperature of the heated part corresponding to the second temperature measuring device in the temperature-controlled pipeline, the control device corresponding to the second temperature measuring device controls the corresponding heating device to heat the heated part. Thus, even if the first temperature measuring device fails, the measured value of the second temperature measuring device corresponding to the first temperature measuring device can be used to achieve temperature control of the corresponding heated part of the temperature-controlled pipeline.

Similarly, due to the possibility of inaccurate measurements from the second temperature measuring device, based on this, in the event of anomalies in the measurements of the second temperature measuring device within a preset time period, the pipeline temperature control method provided in the present disclosure also includes:
S4: When the measured values from both the first temperature measuring device and second temperature measuring device in any heating assemblies become abnormal within their respective preset time periods, through the corresponding control device, controlling the corresponding heating device to follow the heating state of heating device in the adjacent heated part to heat the corresponding heated part.

In other words, in the event of anomalies in the measurements of both the first temperature measuring device and the second temperature measuring device in any heating assembly, the heating state of the heating device in the temperature-controlled pipeline corresponding to an adjacent heated part to the heated part of the heating assembly can also be used as the heating parameters of the heated part with anomalies in both the measurements of the first measuring device and the second temperature measuring device in the temperature-controlled pipeline. This can ensure that the heating device corresponding to the heated part can still continue to perform heating work, and to make the temperature of the heated part close to or even equal to its target temperature.

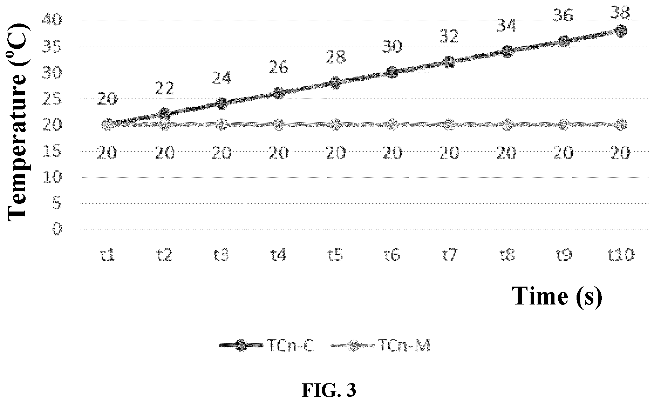

In this regard, as shown in FIG. 3, the step S2 specifically includes:
When the measured value of the first temperature measuring device increases with time within the preset time period, based on the measured value of the first temperature measuring device and a target temperature of a corresponding heated part of the first temperature measuring device, controlling the heating device by the corresponding control device to heat, making a temperature of the heated part meets the target temperature.

In embodiments of the present disclosure, if the measured values of the first temperature measuring device increase with time within a preset time period, the measured values of the first temperature measuring device can be considered to be not anomalous. That is, the measured values of the first temperature measuring device can be used as the actual temperature of the heated part in the temperature-controlled pipeline corresponding to the first temperature measuring device. Then, based on the measured values of the first temperature measuring device and the target temperature of the heated part in the temperature-controlled pipeline corresponding to the first temperature measuring device, the operation of the heating device corresponding to the heated part can be controlled by the control device to heat the heated part. Therefore, the temperature of the heated part can meet the target temperature.

Correspondingly, based on embodiments of the present disclosure, in the event that the measured values of any first temperature measuring device of the multiple heating assemblies satisfies the above conditions, the measured values of the first temperature measuring device can be utilized as the actual temperature of the heated part corresponding to that first temperature measuring device in the temperature-controlled pipeline.

Furthermore, the step S2 can specifically include:
The measured values of both the first temperature measuring device and the second temperature measuring device increase with time within the preset time period. In this case, it can basically be considered that neither the first temperature measuring device nor the second temperature measuring device has any open circuit, short circuit, and poor contact occur.

In the event that the aforementioned conditions are met, if the absolute value of the difference between the measured values of the first temperature measuring device and the second temperature measuring device does not exceed a first preset difference; Or, if the measured value of the first temperature measuring device is greater than the measured value of the second temperature measuring device and the absolute value of the difference between the measured values of the first temperature measuring device and the second temperature measuring device exceeds the first preset difference, it can be considered that the measured value of the first temperature measuring device can be used as the actual temperature of the heated part corresponding to the first temperature measuring device. Here, the actual value of the first preset difference can be determined based on factors such as the types of the first temperature measuring device and the second temperature measuring device, and the temperature control parameters of the temperature-controlled pipeline, and is not limited here.

Specifically, in the event that the absolute value of the difference between the measure values of the first temperature measuring device and the second temperature measuring device does not exceed the first preset difference, it indicates that both the first temperature measuring device and the second temperature measuring device are in normal working condition, and the first preset difference value represents the error range between the two measured values. If the absolute value of the difference between the measured values of the first temperature measuring device and the second temperature measuring device falls within the error range, it indicates that their measurements are relatively accurate. In this case, the measured value of the first temperature measuring device can be used as the actual temperature of the heated part.

If the measured value of the first temperature measuring device is greater than the measured value of the second temperature measuring device, and the absolute value of the difference between the two measured values exceeds the first preset difference value, it indicates that there may be a relatively large distance between the first temperature measuring device and the heated part, or there may be poor contact between the second temperature measuring device and the heated part. However, since the measured value of the second temperature measuring device also increases with time, it can be assumed that the second temperature measuring device still functions normally, while the accuracy of its measured value is relatively low. Therefore, in this case, the measured value of the first temperature measuring device can also be used as the actual temperature of the heated part.

In summary, based on the conditions the measured values of both the first temperature measuring device and the second temperature measuring device increase with time within their respective preset time periods, if the absolute value of the difference between the two measured values does not exceed the first preset difference value, or, if the measured value of the first temperature measuring device is greater than the measured value of the second temperature measuring device and the absolute value of the difference between the two measured values exceeds the first preset difference value, the measured value of the first temperature measuring device and the target temperature of the heated part corresponding to the first temperature measuring device can be used to control the corresponding heating device for heating through the corresponding control device, so that the temperature of the heated part meets the target temperature.

Optionally, as shown in FIG. 3, the step S2 specifically further includes:
When the measured value of the first temperature measuring device increases with time within the preset time period and the measured value of the second temperature measuring device remains unchanged within the preset time period, based on the measured value of the first temperature measuring device and the target temperature of the corresponding heated part of the first temperature measuring device, controlling the heating device by the corresponding control device to heat, making a temperature of the heated part meets the target temperature.

In this embodiment, if the measured value of the second temperature measuring device remains unchanged within the preset time period, it indicates that the second temperature measuring device has experienced a short circuit fault. Based on this, if the measured value of the first temperature measuring device increases with time within the preset time period, it can be assumed that the measured value of the first temperature measuring device is normal. Consequently, the measured value of the first temperature measuring device can be used as the actual temperature of the heated part in the temperature-controlled pipeline corresponding to the first temperature measuring device.

Optionally, the step S3 specifically includes:
Both the measured values of the first temperature measuring device and the second temperature measuring device increase with time within their respective preset time periods. In this case, it can be basically assumed that the first temperature measuring device and the second temperature measuring device are not experiencing open circuit, short circuit, or poor contact.

In the event that the aforementioned conditions are met, if the measured value of the first temperature measuring device is less than the measured value of the second temperature measuring device, and the absolute value of the difference between the measured values of the first temperature measuring device and the second temperature measuring device exceeds the first preset difference value, it can be considered that the measured value of the second temperature measuring device can be used as the actual temperature of the heated part corresponding to the second temperature measuring device.

In detail, when the measured value of the first temperature measuring device is less than the measured value of the second temperature measuring device, and the absolute value of the difference between the two measured values exceeds the preset first difference value, the distance between the first temperature measuring device and the heated part may be relatively large, or the contact relationship between the first temperature measuring device and the heated part may be poor. However, since the measured value of the first temperature measuring device also increases with time, it can be inferred that the first temperature measuring device still has normal functionality, albeit with relatively low accuracy in measurement. Thus, in this scenario, the measured value of the second temperature measuring device can also be utilized as the actual temperature of the heated part.

In summary, based on the condition that the measured values of both the first and second temperature measuring devices increase with time within a preset time period, when the measured value of the first temperature measuring device is less than that of the second temperature measuring device and the absolute value of the difference between the two measured values exceeds the preset first difference value, the measured value of the second temperature measuring device and the target temperature of the heated part corresponding to the second temperature measuring device can be employed. The heating device is controlled by the corresponding control device for heating, so that the temperature of the heated part reaches the target temperature.

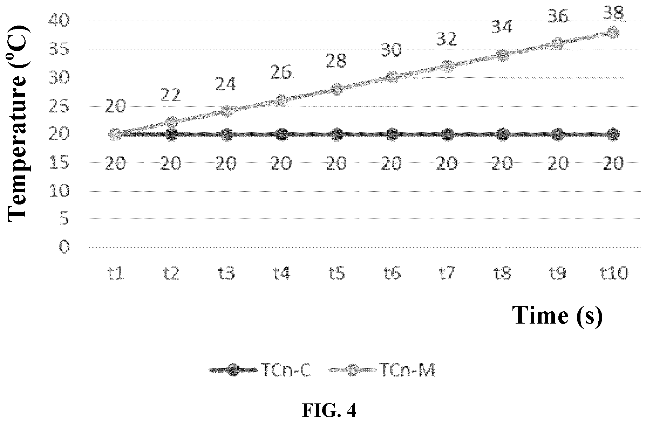

Optionally, as depicted in FIG. 4, the step S3 specifically includes:
When the measured value of the second temperature measuring device increases with time within the preset time period and the measured value of the first temperature measuring device remains unchanged within the preset time period, according to the measured value of the second temperature measuring device and a target temperature of the heated part of a corresponding second temperature measuring device, controlling the heating device by the corresponding control device to heat, making a temperature of the heated part meets the target temperature.

In this embodiment, if the measured value of the first temperature measuring device does not change within the preset time period, it is considered that the first temperature measuring device has a short circuit fault. On this basis, if the measured value of the second temperature measuring device increases with time within the preset time period, it is considered that the measured value of the second temperature measuring device meets the normal situation. Consequently, the measured value of the second temperature measuring device can be utilized as the actual temperature of the heated part in the temperature-controlled pipeline corresponding to the second temperature measuring device.

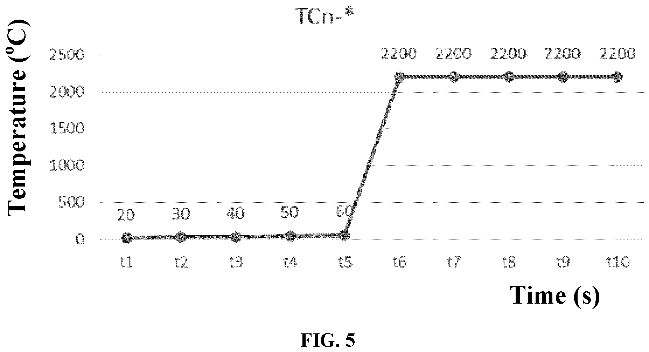

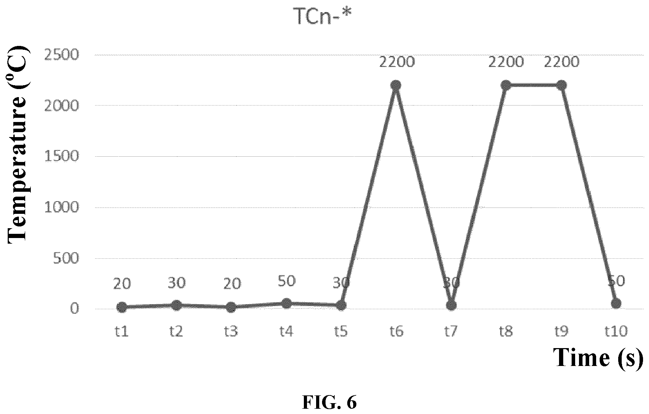

Optionally, as shown in FIG. 5 and FIG. 6, the specific step S3 described above further includes:
In the case where the measured value of the first temperature measuring device continuously exceeds a first preset value within the preset time period, or the jump amplitude of the measured value of the first temperature measuring device exceeds a second preset value for a preset number of times within the preset time period, it can also be considered that the measured value of the first temperature measuring device is abnormal.

Specifically, for the measured value of the first temperature measuring device within the preset time period, if it continuously exceeds the first preset value, it indicates that the first temperature measuring device has an open circuit fault. In this case, the measurement value of the first temperature measuring device will usually be displayed as the value of its maximum range. Furthermore, the first preset value can specifically be a value higher than the highest controlled temperature of the temperature-controlled pipeline. Therefore, once the measured value of the first temperature measuring device exceeds the first preset value, it can be determined that the first temperature measuring device is abnormal, and it is highly possible that it has an open-circuit fault. The measured value of the first temperature measuring device cannot be used as the actual temperature of the heated part corresponding to the first temperature measuring device.

If the jump amplitude of the measured value of the first temperature measuring device within the preset time period exceeds a second preset value, and the number of times it exceeds reaches the preset number of times, it indicates that the first temperature measuring device has poor contact. Therefore, the measured value of the first temperature measuring device cannot be used as the actual temperature of the heated part corresponding to the first temperature measuring device. The jump refers to a significant difference between the measured values of the first temperature measuring device at two adjacent time points. If the amplitude of the difference exceeds the second preset value, and the difference occurs frequently within the preset time period, i.e., exceeding the second preset value, it can be considered that this difference is not caused by the performance of the first temperature measuring device but by the fault of the first temperature measuring device.

Based on the above situation, if the measured value of the second temperature measuring device increases with time within the preset time period, it is considered that the measured value of the second temperature measuring device can be used as the actual temperature of the heated part corresponding to the second temperature measuring device. By utilizing the measured value and the target temperature of the heated part corresponding to the second temperature measuring device, the corresponding heating device is controlled by the corresponding control device to heat, thereby ensuring the temperature of the heated part meet the target temperature.

Additionally, in the above embodiments, if the data used by the control device when controlling the operation of the heating device comes from the second temperature measuring device in the heating assembly, it indicates that the first temperature measuring device in the heating assembly is abnormal. In this case, an alarm signal can also be sent. The alarm signal includes information about the abnormality of the first temperature measuring device in the aforementioned heating assembly.

Optionally, as shown in FIG. 4, the step S4 specifically includes:
When the measured value of the first temperature measuring device becomes abnormal within the preset time period, and the measured value of the second temperature measuring device continuously exceeds the first preset value or the jump amplitude exceeds the second preset value for a preset number of times within the preset time period, the corresponding heating device is controlled by the corresponding control device to follow the heating state of the heating device in an adjacent heated part to heat the heated part.

In this embodiment, if the measured value of the second temperature measuring device does not change within the preset time period, it is considered that the second temperature measuring device has a short circuit fault. That is, the measured value of the second temperature measuring device cannot be used as the actual temperature of the heated part corresponding to the second temperature measuring device.

Based on this, this embodiment uses the heating state of the heating device corresponding to the heated part adjacent to the aforementioned heated part to provide heating parameters for the heating device corresponding to the aforementioned faulty second temperature measuring device, ensuring that the heating device corresponds to the aforementioned faulty second temperature measuring device can still continue to perform heating operation. The heated part corresponding to the aforementioned faulty second temperature measuring device can continue to be heated to a temperature close to or even equal to its target temperature. Of course, in this embodiment, the first temperature measuring device corresponding to the aforementioned faulty second temperature measuring device also has abnormalities.

In more detail, the heated part corresponding to the aforementioned faulty second temperature measuring device may specifically be a first heated part, and the heated part adjacent to the first heated part may specifically be a second heated part. The second heated part may be located downstream of the first heated part, or may be located upstream of the first heated part, which is not limited herein. However, when selecting the second heated part, the heated part downstream of the first heated part is preferably selected as the second heated part, which causes the probability of temperature of the temperature-controlled pipeline along the direction of fluid transportation being over-temperature is relatively small.

Optionally, as shown in FIGS 5 and 6, the step S4 specifically also includes:
When the measured value of the second temperature measuring device continues to exceed the first preset value within a preset time period or the jump amplitude exceeds the second preset value for a preset number of times, the corresponding heating device is controlled by the corresponding control device to follow the heating state of the heating device in the adjacent heated part to heat the heated part.

Specifically, for the measured value of the second temperature measuring device within the preset time period, if it continues to exceed the first preset value, it means that the second temperature measuring device has an open circuit fault. In this case, the measured value of the second temperature measuring device will usually be displayed as the value of its maximum range. Furthermore, the first preset value can be a value higher than the maximum temperature of the temperature-controlled pipeline. Therefore, once the measured value of the second temperature measuring device exceeds the first preset value, it can be determined that the second temperature measuring device is abnormal, and there is a high probability that it has an open circuit failure. The measured value of the second temperature measuring device cannot be used as the actual temperature of the heated part corresponding to the second temperature measuring device.

If the jump amplitude of the measured value of the second temperature measuring device within the preset time period exceeds the second preset value, and the number of times exceeds the preset number of times, it means that the second temperature measuring device has poor contact. Furthermore, the measured value of the second temperature measuring device cannot be used as the actual temperature of the heated part corresponding to the second temperature measuring device. Specifically, the jump means that there is a large difference between the measured values of the second temperature measuring device at two adjacent time points, the amplitude of the difference exceeds the second preset value, and the aforementioned difference occurs frequently within the preset time period, that is, exceeds the second preset value. It can be considered that the difference is not caused by the performance of the second temperature measuring device, but the second temperature measuring device is faulty.

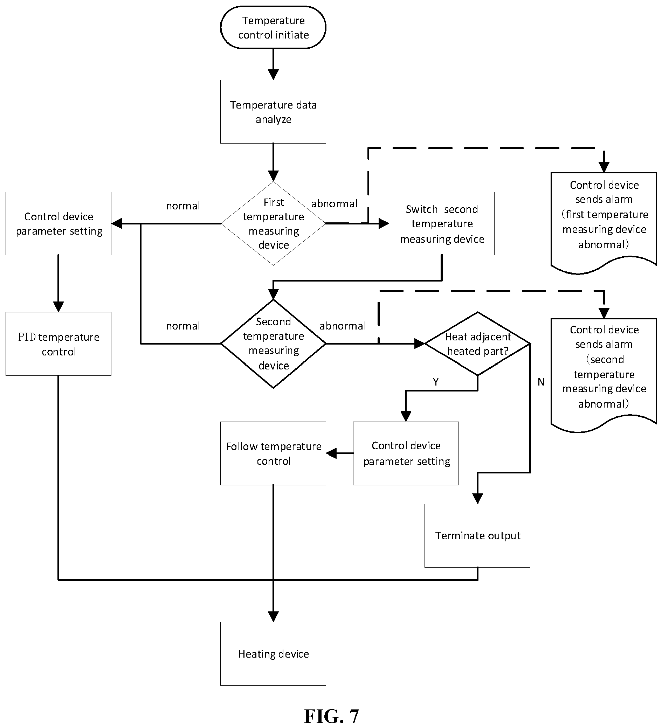

Based on this, as shown in FIG. 7, the pipeline temperature control method provided by this embodiment analyzes the temperature data of the heated part to determine whether the measured value of the first temperature measuring device corresponding to the heated part is abnormal. If it is normal, the measured value of the first temperature measuring device is used as the actual temperature, and the corresponding parameters are set by the corresponding control device to perform PID temperature-control heating so that the heated part meets the target temperature. If the measured value of the first temperature measuring device is abnormal, the processing device will alarm to prompt that the first temperature measuring device is abnormal, and at the same time determine whether the measured value of the second temperature measuring device is abnormal. If it is normal, use the measured value of the second temperature measuring device as the actual temperature, and set the corresponding parameters through the corresponding control device to perform PID temperature-control heating so that the heated part meets the target temperature. If the measured value of the second temperature measuring device is also abnormal, the alarm of the processing device is used to prompt that the second temperature measuring device is abnormal, and at the same time, the heating state of the heating device in the heated part adjacent to the aforementioned heated part is used to provide heating parameters to the heated part corresponding to the faulty second temperature measuring device. This ensures that the heating device corresponding to the aforementioned faulty second temperature measuring device can still continue to perform heating work, and the heated part corresponding to the aforementioned faulty second temperature measuring device can still continue to be heated to be close to or even equal to its target temperature. Of course, in this embodiment, the heating device in the adjacent heated part is in the heating state. Otherwise, the temperature control program will be exited directly and the heating will be cut off.

In more detail, the heated part corresponding to the aforementioned faulty second temperature measuring device may specifically be the first heated part, and the heated part adjacent to the aforementioned first heated part may specifically be the second heated part. The second heated part may be located downstream of the first heated part, or may be located upstream of the first heated part, which is not limited herein.

Among them, as shown in Table 1, along the extension direction of the temperature-controlled pipeline, from the flow direction of the fluid in the pipeline, the heated parts Z₁, Z₂...Z₍ₙ₋₁₎ and Zₙ are distributed adjacently in sequence. Z₁ is located at the most upstream of the temperature-controlled pipeline, and Zₙ is located at the most downstream of the temperature-controlled pipeline. When actually selecting the second heated part, the heated part Zₙ downstream of the first heated part Zₙ₋₁ (n≤m) is preferably selected as the second heated part, which makes a better temperature accuracy of the temperature-controlled pipeline. Of course, if the first heated part is the most downstream heated part on the temperature-controlled pipeline, that is when it is Zₙ, the adjacent heated part Zₙ₋₁ upstream of the first heated part Zₙ can be selected as the second heated part.

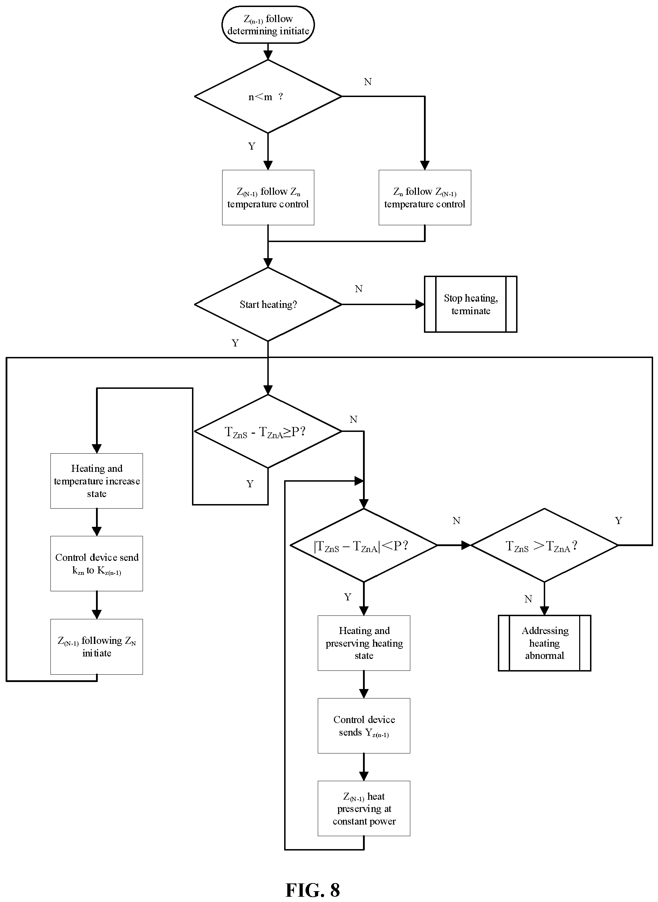

FIG. 8 shows a specific schematic diagram of partial flow chart in the pipeline temperature control method. In FIG. 8, P is the reference value of the temperature control range. In the case of T_{ZnS} - T_{ZnA}≥P, it means that there is still a large difference between the current temperature of the heated part and the target temperature, and the heated part needs to continue to be heated. In the case of |T_{ZnS} - T_{ZnA}|<P, it means that the current temperature of the heated part is close to the target temperature, meeting the temperature control requirements, and can enter the heating preserving state. At the same time, it must determine whether the current temperature is greater than the target temperature. If yes, it means that there is heating abnormality, requiring specially handling. During the temperature control process, the temperature control parameters of each heated part are as follows:

| Heated parts | Z₁ | Z₂ | ... | Z₍ₙ₋₁₎ | Zₙ |
|---|---|---|---|---|---|
| Target temperatures of heated parts (°C) | T_{Z1S} | T_{Z2S} | ... | T_{Z(n-1)S} | T_{ZnS} |
| Current temperatures of heated parts (°C) | T_{Z1A} | T_{Z2A} | ... | T_{Z(n-1)A} | T_{ZnA} |
| Rated power of heating device (W) | P_{Z1} | P_{Z2} | ... | P_{Z(n-1)} | P_{Zn} |
| Current output parameters of the heated parts | k_{Z1} | k_{Z2} | ... | k_{Z(n-1)} | k_{Zn} |
| Heat preservation power of heated parts (W) | Y_{Z1} | Y_{Z2} | ... | Y_{Z(n-1)} | Y_{Zn} |

Moreover, among the multiple heating assemblies, the first heating assembly corresponds to the first heated part, the second heating assembly corresponds to the second heated part, and the first heating assembly and the second heating assembly are arranged adjacently. Based on the description above, when the measured values of both the first temperature measuring device and the second temperature measuring device in the first heating assembly are abnormal within the preset time period:

The above method uses the corresponding control device to control the corresponding heating device to follow the heating state of the heating device in the adjacent heated part to heat the heated part. Specifically, it includes:
According to the measured value of the first temperature measuring device of the second heating assembly and the target temperature of the heated part in the temperature-controlled pipeline corresponding to the second heating assembly, the heating device of the first heating assembly is controlled by the control device of the first heating assembly to heat the heated part in the temperature-controlled pipeline corresponding to the first heating assembly. Thus, the temperature of the heated part corresponding to the first heating assembly satisfies the target temperature of the heated part corresponding to the second heating assembly.

That is, if both the first temperature measuring device and the second temperature measuring device in the first heating assembly have abnormal functions, it is necessary to use the heating parameters of the second heating assembly adjacent to the first heating assembly to heat the heated part corresponding to the first heating assembly. During the heating process, the parameters used are the temperature parameters measured by the first temperature measuring device in the second heating assembly. Based on the target temperature of the heated part corresponding to the second heating assembly, the control device in the first heating assembly is used to control the operation of the heating device in the first heating assembly to heat the heated part corresponding to the first heating assembly, so that the temperature of the heated part corresponding to the first heating assembly meets the target temperature of the heated part corresponding to the second heating assembly. This ensures the continuation of the process, prevents wafer scrapping due to process termination, and reduces losses and costs.

In addition, in the above embodiment, when the control device is controlling the operation of the heating device and the adopted data comes from the heating device in another heating assembly adjacent to the aforementioned heating assembly, it means that both the first temperature measuring device and the second temperature measuring device in the aforementioned heating assembly are abnormal. In this case, an alarm signal can also be sent. The alarm signal includes information of both the first temperature measuring device and the second temperature measuring device in the aforementioned heating assembly being abnormal.

Based on the pipeline temperature control method disclosed in the above embodiments, as shown in FIGS. 7 and 8, embodiments of the present disclosure also provide the following content. In the pipeline temperature control equipment, the multiple heating assemblies may specifically be two heating assemblies, and they may be a first heating assembly and a second heating assembly respectively. Of course, the number of heating assemblies can also be three, four, five or more. Correspondingly, the heating assemblies can be respectively the first heating assembly, the second heating assembly, the third heating assembly... and the nth heating assembly. Correspondingly, the heated parts corresponding to the first heating assembly, the second heating assembly, the third heating assembly... the nth heating assembly in the temperature-controlled pipeline are respectively the first heated part, the second heated part, the third heated parts...the nth heated part. They are adjacent in sequence along the extension direction of the temperature-controlled pipeline.

Based on the above content, the step S2 may specifically include:
S21: When the measured value of the first temperature measuring device in the first heating assembly increases with time within the preset time period, according to the measured value of the first temperature measuring device and the first target temperature of the first heated part in the temperature-controlled pipeline corresponding to the first heating assembly, the heating device of the first heating assembly is controlled to operate at the first power for the first preset time, so that the temperature of the first heated part meets the first target temperature.

That is to say, if the first temperature measuring device in the first heating assembly is in normal operation state, the measured value of the first temperature measuring device and the first target temperature of the first heated part are used to control the operation of the heating device in the first heating assembly. Therefore, the temperature of the first heated part meets the first target temperature, that is, the temperature indicated by the temperature control command.

Among them, the first target temperature can be a preset temperature, which can be determined based on factors such as the material of the first heated part and the type and flow rate of the medium being transported. Specifically, the temperature set in the actual application shall prevail. In this implementation, there are no specific limitations in the examples. It should be noted that if the measured value of the first temperature measuring device in the first heating assembly increases with time within the preset time period, it is considered that the first temperature measuring device can provide normal temperature measurement data and meet the conditions for it to be in a normal operation state. The aforementioned normal operation is a relative result, not that the operation state of the first temperature measuring device is normal in an absolute sense.

S22: When the measured value of the first temperature measuring device in the first heating assembly does not increase with the time within the preset time period, and the measured value of the second temperature measuring device in the first heating assembly increases with the time within the preset time period, according to the measured value of the second temperature measuring device and the first target temperature of the first heated part in the temperature-controlled pipeline corresponding to the first heating assembly, the heating device controlled by the first heating assembly operates at the first power for the first preset time, so that the temperature of the first heated part meets the first target temperature.

In this embodiment, if the first temperature measuring device in the first heating assembly is in a non-operation state, that is, it is in an abnormal state, and the second temperature measuring device is in a normal operation state, the measured value of the second temperature measuring device and the first target temperature of the first heated part are used to control the operation of the heating device of the first heating assembly. Thus, the temperature of the first heated part meets the first target temperature, that is, the temperature indicated by the temperature control command.

That is to say, if the measured value of the first temperature measuring device does not increase with the time within a period of time, and the measured value of the second temperature measuring device increases with the time during the aforementioned time period, this indicates that the first temperature measuring device is likely to malfunction, and the temperature data measured by the first temperature measuring device cannot be used as temperature control data.

In embodiments of the present disclosure, the temperature control command is first received. If the measured value of the first temperature measuring device in the first heating assembly increases with time within a preset time period, the first temperature measuring device is considered to be in normal operation state. The measured value of the first temperature measuring device and the first target temperature of the heated part can be further used to control the heating device of the first heating assembly to operate at the first power for the first preset time period. Then, the temperature of the first heated part meets the first target temperature. If the measured value of the first temperature measuring device does not increase with the time within the preset time period, and the measured value of the second temperature measuring device in the first heating assembly increases with the time within the preset time period, the first temperature measuring device is considered to be in an abnormal operation state, and the second temperature measuring device is in a normal operation state. Then, the measured value of the second temperature measuring device and the first target temperature of the heated part can be used to control the heating device of the first heating assembly to operate at the first power for a first preset time period, so that the temperature of the first heated part meets the first target temperature.

In embodiments of the present disclosure, when the first temperature measuring device in the first heating assembly is working normally, the temperature measured by the first temperature measuring device is used to control the heating device of the first heating assembly to heat the first heated part. When the first temperature measuring device does not work normally and the second temperature measuring device in the first heating assembly works normally, the temperature measured by the second temperature measuring device is used to control the heating device to heat the first heated part. When one of the first temperature measuring device and the second temperature measuring device is abnormal, the other one can be used to measure the temperature of the corresponding first heated part in the temperature-controlled pipeline to prevent the failure of the pipeline temperature control equipment caused by any abnormal temperature device (damage or poor contact, etc.), which will cause the termination of the wafer processing process, drive up the production cost, and result in process lag. When the aforementioned technical solution is adopted, the aforementioned issues can be solved to a certain extent and the continuity of the process can be ensured within a certain range.

Further, in another embodiment of the present disclosure, step S21 includes:
S211: The measured values of both the first temperature measuring device and the second temperature measuring device in the first heating assembly increase with time within the preset time period, and the absolute value of the difference between the measured values of the first temperature measuring device and the second temperature measuring device is less than or equal to the first preset difference, based on the measured value of the first temperature measuring device and the first target temperature of the first heated part in the temperature-controlled pipeline corresponding to the first heating assembly, the heating device of the first heating assembly is controlled to operate at a first power for a first preset time period, so that the temperature of the first heated part meets the first target temperature.

In this embodiment, if the measured values of both the first temperature measuring device and the second temperature measuring device in the first heating assembly increase with time, it can be considered that both are in the aforementioned normal operation state. In order to further improve the temperature control accuracy of the first heated part in the temperature-controlled pipeline, it can be further determined by judging the relationship between the absolute value of the difference between the measured values of the first temperature measuring device and the second temperature measuring device and the first preset value. When the absolute value of the difference between the measured values of the first temperature measuring device and the second temperature measuring device is less than or equal to the first preset difference, it means the accuracy of the measured values of the first temperature measuring device and the second temperature measuring device is relatively high, and the measured values of the first temperature measuring device and the second temperature measuring device are basically the true temperatures of the first heated part. On this basis, the measured value of the first temperature measuring device and the first target temperature of the first heated part can be used to control the heating device to operate at the first power for the first preset time period, so that the temperature of the first heated part meets the first target temperature.

In this embodiment, by comparing the temperatures measured by the first temperature measuring device and the second temperature measuring device, it can be more accurately determined whether the first temperature measuring device is in a normal working state. Thus, the controlled temperature of the first heated part can be closer to the first target temperature, making the heating result more accurate, thereby improving the process effect.

As mentioned above, the multiple heating assemblies of the pipeline temperature control equipment include a first heating assembly, and the first heating assembly is used to control the temperature of the first heated part in the temperature-controlled pipeline. Optionally, in this embodiment, the multiple heating assemblies of the pipeline temperature control equipment include a second heating assembly. Similarly, the second heating assembly is used to temperature control the second heated part in the temperature-controlled pipeline corresponding to the second heating assembly. The first heating assembly and the second heating assembly are distributed along the extension direction of the temperature-controlled pipeline. Based on the aforementioned pipeline temperature control equipment, in the pipeline temperature control method provided in this embodiment, after the step S1, the pipeline temperature control method also includes:
S23: When the measured values of both the first temperature measuring device and the second temperature measuring device in the first heating assembly increase with time within the preset time period, the absolute of the difference between first temperature measuring device and the second temperature measuring device is greater than the first preset difference, and the heating device of the second heating assembly is working, according to the measured value of the first temperature measuring device in the second heating assembly and the second target temperature of the second heated part in the temperature-controlled pipeline corresponding to the second heating assembly, the heating device of the first heating assembly is controlled to operate at a second power for a second preset time period so that the temperature of the first heated part meets the second target temperature.

In this embodiment, similar to the previous embodiment, if the measured values of both the first temperature measuring device and the second temperature measuring device in the first heating assembly both increase with time, it can be considered that both are in the normal operation state. At the same time, the absolute value of the difference between the measured values of the first temperature measuring device and the second temperature measuring device can also be compared with the above-mentioned first preset difference to further improve the accuracy of the first temperature measuring device and the second temperature measuring device. Correspondingly, when the absolute value of the difference between the measured values of the first temperature measuring device and the second temperature measuring device is greater than the first preset difference, it means that at least one of the first temperature measuring device and the second temperature measuring device is abnormal. On this basis, since it cannot directly determine which one of the first temperature measuring device and the second temperature measuring device is abnormal, to ensure the reliability of the temperature control operation, neither the measured value of first temperature measuring device nor the measured value of second temperature measuring device can be used as the actual temperature of the first heated part in the temperature-controlled pipeline.

The first heated part and the second heated part in the temperature-controlled pipeline are spatially adjacent to each other, and the medium transported in the temperature-controlled pipeline will go through the first heated part and the second heated part. Based on this, in this embodiment, the temperature of the second heated part adjacent to the first heated part in the temperature-controlled pipeline can be used as the real-time temperature of the first heated part. Of course, the premise of the above situation is that the second heating assembly is in the operation state. Therefore, when the heating device of the second heating assembly is in the operation state, based on the measured value of the first temperature measuring device of the second heating assembly and the second target temperature of the second heated part in the temperature-controlled pipeline corresponding to the second heating assembly, the heating device of the first heating assembly is controlled to operate at a second power for a second preset time period, so that the temperature of the first heated part meets the second target temperature.

When the above technical solution is adopted, even if there is a probability that the measured values of the first temperature measuring device and the second temperature measuring device in the first heating assembly are inaccurate, the relevant data in the second heating assembly can also be used to control the continuous operation of the first heating assembly to further ensure the continuation of the process, prevent wafer scrapping due to process termination, and reduce losses and costs.

Preferably, the second heating assembly may be the closest one to the first heating assembly in the extension direction of the temperature-controlled pipeline among the multiple heating assemblies. When using the corresponding data of the second heating assembly to control the operation of the first heating assembly, the second target temperature reached by the first heated part can be closer to the first target temperature which is originally shall be heated to. This further improves the accuracy of the temperature of the medium transported by the temperature-controlled pipeline when it is transported to the process chamber.

As mentioned above, the multiple heating assemblies in the pipeline temperature control equipment provided by the present disclosure include a first heating assembly and a second heating assembly. Based on this, in the pipeline temperature control method provided by embodiments of the present disclosure, after the step S1, the pipeline temperature control method also includes:
S24: When the measured values of both the first temperature measuring device and the second temperature measuring device in the first heating assembly do not increase with time within the preset time period, and the heating devices in the first heating assembly and the second heating assembly are all working, according to the measured value of the first temperature measuring device in the second heating assembly and the second target temperature of the second heated part in the temperature-controlled pipeline corresponding to the second heating assembly, the heating device of the first heating assembly is controlled to operate at a second power for a second preset time period, so that the temperature of the first heated part meets the second target temperature.

In this embodiment, if the measured values of the two temperature measuring devices in the first heating assembly do not increase with time within the preset time period, and the heating device in the first heating assembly is working, it means that the heating device of the first heating assembly has an output current, but neither the first temperature measuring device nor the second temperature measuring device in the first heating assembly correspondingly feedback the heating result of the heating devices. In this case, it is determined that both the first temperature measuring device and the second temperature measuring device are in an abnormal state. In this case, the measured value of the first heating assembly cannot be used to control the heating operation of the first heating assembly.

In order to ensure the continuous progress of the process, the relevant data of the second heating assembly can still be used as the data of the first heated part to control the first heating assembly. Of course, in the aforementioned technical solution, it is also necessary to determine whether the second heating device is in operation state. When the heating device of the second heating assembly is in the operation state, the second target temperature of the second heated part corresponding to the second heating assembly can be used to control the heating device in the first heating assembly to operate at a second power for a second preset time period, so that the temperature of the first heated part meets the second target temperature.

When the above technical solution is adopted, the relevant data of the second heating assembly can also be used to control the operation of the first heating assembly to ensure that the first heating assembly can still heat the temperature of the first heated part in the temperature-controlled pipeline to a second target temperature that is relatively close to the first target temperature, ensuring the continuation of the process and preventing the wafer from being scrapped due to process termination.

As mentioned above, when the first temperature measuring device and the second temperature measuring device of the first heating assembly are abnormal, the relevant data of the second heating assembly can be used to control the temperature of the first heated part. On this basis, the above pipeline temperature control method can also include:

When the heating device of the first heating assembly is controlled to operate at the second power, a first alarm signal is sent. The first alarm signal includes the abnormal operation of the first temperature measuring device and/or the second temperature measuring device in the first heating assembly.

That is to say, if the first heating assembly operates at the second power, it means that at least one of the first temperature measuring device and the second temperature measuring device in the first heating assembly is in an abnormal state. The first alarm signal can be sent to prompt the staff or the processing device to know that at least one of the first temperature measuring device and the second temperature measuring device in the first heating assembly is abnormal. This enables staff to find issues or replace devices in a timely manner, ensuring that subsequent process results can better meet requirements.

During the process, the medium transported in the temperature-controlled pipeline may be intermittently sent into the process chamber. Based on this, in order to ensure that the temperature of the transported medium can still maintain the required temperature when it is sent into the process chamber. Optionally, in this embodiment, the pipeline temperature control method also includes:
S3: After the heating device of the first heating assembly operates at the second power for the second preset time period, controlling the heating device in the first heating assembly to operate at a third power to maintain the temperature of the first heated part to meet the first target temperature.

That is to say, after the temperature of the first heated part in the first heating assembly reaches the second target temperature, the heating device in the first heating assembly continues to operate to maintain the temperature of the first heated part. Furthermore, by using the first heating assembly to maintain the temperature of the first heated part at a third power that can make the temperature of the first heated part to meet the first target temperature. By heat preserving, the temperature of the first heated part that was originally heated to the second target temperature can further be directed to meet the originally set first target temperature. This results in a better temperature control effect of the medium transported in the temperature-controlled pipeline and an improved process result.

It should be noted that the amount of heat dissipated by the medium contained in the first heated part per unit time can be determined based on the material of the first heated part, as well as the type and flow rate of the transported medium. Based on this, the heat required to maintain the temperature of the first heated part at the first target temperature per unit time can be obtained, and then the specific parameters of the third power can be obtained.

As mentioned above, by controlling the heating device of the first heating assembly to operate at the first power for the first preset time period, the temperature of the first heated part can be made to meet the first target temperature. Optionally, meeting the first target temperature may specifically be equal to the first target temperature. In another embodiment of the present disclosure, satisfying the first target temperature may also be that the absolute value of the difference between the value of the first target temperature and the value of the real-time temperature of the first heated part is less than the second preset difference. In other words, by expanding the conditions for satisfying the first target temperature and reducing the strictness of the determining process, if the temperature of the first heated part is within a range, it is considered that the first target temperature is met, which expands the applicability of the pipeline temperature control method.

As mentioned above, when the heating device of the first heating assembly operates at the second power for the second preset time period so that the temperature of the first heated part meets the second target temperature, the first heated part can be kept warm. This ensures that the temperature of the medium during being transported to the process chamber still meets the required temperature, and the process effect will not be adversely affected due to heat loss.

Similarly, when the heating device in the first heating assembly operates at the first power for the first preset time, heating and heat preservation can also be used to ensure that the temperature of the medium in the first heated part can meet the first target temperature for a long time. Based on this, in this embodiment, the pipeline temperature control method also includes:
S4: After the heating device in the first heating assembly operates at the first power for the first preset time period, controlling the first heating assembly to operate at the third power to maintain the absolute value of the difference between the temperature of the first heated part and the first target temperature being equal to or less than the third preset difference. When the technical solution provided by this embodiment is adopted, the temperature of the medium in the first heated part can be made to meet the first target temperature for a long time through continuous heat preservation, thereby ensuring that the temperature of the medium transported to the process chamber can meet the required temperature. The temperature will not decrease due to the heat dissipation of the medium over time, avoiding adverse influence on the process effect.

In the step S4, continuous heating is used so that the medium in the first heated part can meet the first target temperature. However, during actual application, the insulation may fail due to unexpected circumstances. Based on this, in this embodiment, the pipeline temperature control method further includes:
S51: Sending a temperature control command when the first heating assembly operates at a third power for a third preset time period and the difference between the first target temperature and the temperature of the first heated part is less than the third preset difference.

In this embodiment, after the first heating assembly operates at the third power for the third preset time period, if the difference between the first target temperature and the temperature of the first heated part is less than the third preset difference, it means that the current temperature of the first heated part is lower than the first target temperature and no longer meets the first target temperature. Therefore, the medium in the first heated part needs to be reheated so that the temperature of the medium meets the first target temperature again. Based on this, the temperature control command is sent, and the above-mentioned S 1 is re-executed, as well as the subsequent steps corresponding to S1. The foregoing solutions have been described in detail in the above-mentioned embodiments. Considering the brevity of the text, they will not be described again in this embodiment.

Correspondingly, the pipeline temperature control method can also include:
S52: When the first heating assembly operates at a third power for a third preset time period, and the difference between the temperature of the first heated part and the first target temperature is greater than the third preset difference, the heating device in the first heating assembly is controlled to stop working, and a second alarm signal is sent. The second alarm signal includes the abnormal information of maintaining a constant temperature through heating.

In this embodiment, after the first heating assembly operates at the third power for the third preset time period, if the difference between the temperature of the first heated part and the first target temperature is greater than the third preset difference, it means that the current temperature of a heated part is already higher than the first target temperature, and the temperature of the first heated part no longer meets the first target temperature, which indicates that the heating device of the first heating assembly may not perform maintaining a constant temperature through heating according to the third power, or there is a measurement abnormality in the first temperature measuring device and/or the second temperature measuring device in the first heating assembly. In this case, it means that the heating device of the first heating assembly is in an abnormal working state. Correspondingly, it is necessary to control the heating device of the first heating assembly to stop working, to prevent safety issues caused by overheating the medium, and to prevent device damage. At the same time, a second alarm signal is also sent to remind the staff and/or the processing device that there is a heating abnormality in the first heating assembly, so that the issue can be found or the device can be replaced in a timely manner.

The above embodiments of this application focus on the differences between the various embodiments. As long as the different optimization features between the various embodiments are not inconsistent, they can be combined to form a better embodiment. Considering the brevity of the text, they will not be described again.

The above descriptions are only examples of the present disclosure and are not intended to limit the present application. To those persons of skilled in the art, various modifications and variations may be made to this application. Any modifications, equivalent substitutions, improvements, etc. made within the spirit and principles of this application shall be included in the scope of the claims of the present disclosure.

## Claims

1. A pipeline temperature control equipment, used in a semiconductor equipment, comprising a processing device and multiple heating assemblies, wherein the multiple heating assemblies are distributed along an extension direction of a temperature-controlled pipeline to correspondingly control temperatures of multiple heated parts of the temperature-controlled pipeline, and each of the multiple heating assemblies comprises a heating device, a first temperature measuring device, a second temperature measuring device, and a control device;
both the first temperature measuring device and the second temperature measuring device in each heating assembly are used to measure a real-time temperature of a heated part of the multiple heated parts in the temperature-controlled pipeline corresponding to the heating device in the heating assembly; both the first temperature measuring device and the second temperature measuring device in each heating assembly are connected to the control device in the heating assembly; and multiple control devices are connected to the processing device;
the processing device is configured to, according to respective target temperatures of each of the multiple heated parts in the temperature-controlled pipeline and respective measured values of first temperature measuring devices of the multiple heating assemblies, control operations of multiple heating devices through the multiple control devices respectively, until temperatures of the multiple heated parts meet the respective target temperatures;
the processing device is further configured to, when a measured value of the first temperature measuring device is abnormal within a preset time period, according to a measured value of a corresponding second temperature measuring device and a target temperature of a corresponding heated part, control a corresponding heating device by a corresponding control device to heat the heated part; and
the processing device is further configured to, when measured values of both the first temperature measuring device and the second temperature measuring device in any one of the multiple heating assemblies are abnormal within their respective preset time periods, control the corresponding heating device by the corresponding control device to follow a heating state of a heating device of an adjacent heated part to heat the heated part.

2. A pipeline temperature control method, applied to the pipeline temperature control temperature according to claim 1, comprising:
S1: receiving a temperature control command;
S2: according to the respective target temperatures of the multiple heated parts in the temperature-controlled pipeline and the respective measured values of first temperature measuring devices of the multiple heating assemblies, controlling the operations of multiple heating devices through the multiple control devices respectively, until temperatures of the multiple heated parts meet the respective target temperatures;
S3: when the measured value of the first temperature measuring device is abnormal within the preset time period, according to the measured value of the corresponding second temperature measuring device and the target temperature of the corresponding heated part, controlling the corresponding heating device by a corresponding control device to heat the heated part;
S4: when the measured values of both the first temperature measuring device and the second temperature measuring device in any one of the multiple heating assemblies are abnormal within their respective preset time periods, controlling the corresponding heating device by the corresponding control device to follow the heating state of the heating device of the adjacent heated part to heat the heated part.

3. The pipeline temperature control method according to claim 2, wherein the step S2 comprises:
when the measured value of the first temperature measuring device increases with time within the preset time period, according to the measured value of the first temperature measuring device and a target temperature of a heated part corresponding to the first temperature measuring device, controlling the corresponding heating device by the corresponding control device to heat, making a temperature of the heated part meet the target temperature.

4. The pipeline temperature control method according to claim 3, wherein the step S2 comprises:
when the measured values of both the first temperature measuring device and the second temperature measuring device increase with time within the preset time period, and an absolute value of a difference between the measured value of the first temperature measuring device and a measured value of the second temperature measuring device does not exceed a first preset difference; or, the measured value of the first temperature measuring device is greater than the measured value of the second temperature measuring device, and the absolute value of the difference between the measured value of the first temperature measuring device and the measured value of the second temperature measuring device exceeds the first preset difference, according to the measured value of the first temperature measuring device and the target temperature of the heated part corresponding to the first temperature measuring device, controlling the corresponding heating device by the corresponding control device to heat, making a temperature of the heated part meet the target temperature.

5. The pipeline temperature control method according to claim 3, wherein the step S2
comprises:
when the measured value of the first temperature measuring device increases with time within the preset time period and a measured value of the second temperature measuring device remains unchanged within the preset time period, according to the measured value of the first temperature measuring device and the target temperature of the heated part corresponding to the first temperature measuring device, controlling the corresponding heating device by the corresponding control device to heat, making a temperature of the heated part meet the target temperature.

6. The pipeline temperature control method according to claim 2, wherein the step S3
comprises:
when the measured values of both the first temperature measuring device and the second temperature measuring device increase with time within the preset time period, the measured value of the first temperature measuring device is less than a measured value of the second temperature measuring device, and an absolute value of a difference between the measured value of the first temperature measuring device and a measured value of the second temperature measuring device exceeds a first preset difference, according to the measured value of the second temperature measuring device and a target temperature of the heated part corresponding to the second temperature measuring device, controlling the corresponding heating device by the corresponding control device to heat, making a temperature of the heated part meet the target temperature.

7. The pipeline temperature control method according to claim 2, wherein the step S3
comprises:
when a measured value of the second temperature measuring device increases with time within the preset time period and the measured value of the first temperature measuring device remains unchanged within the preset time period, according to the measured value of the second temperature measuring device and a target temperature of a heated part corresponding to the second temperature measuring device, controlling the corresponding heating device by the corresponding control device to heat, making a temperature of the heated part meet the target temperature.

8. The pipeline temperature control method according to claim 2, wherein the step S3
comprises:
when the measured value of the first temperature measuring device continues to exceed a first preset value or a jump amplitude exceeds a second preset value for a preset number of times within the preset time period, and a measured value of the second temperature measuring device increases with time within the preset time period, according to the measured value of the second temperature measuring device and a target temperature of a heated part corresponding to the second temperature measuring device, controlling the corresponding heating device by the corresponding control device to heat, making a temperature of the heated part meet the target temperature.

9. The pipeline temperature control method according to claim 2, wherein the step S4
comprises:
when a measured value of the second temperature measuring device remains unchanged within the preset time period, controlling the corresponding heating device by the corresponding control device to follow the heating state of the heating device of the adjacent heated part to heat the heated part.

10. The pipeline temperature control method according to claim 2, wherein the step S4
comprises:
when the measured value of the first temperature measuring device is abnormal within the preset time period, and a measured value of the second temperature measuring device continues to exceed a first preset value or a jump amplitude exceeds a second preset value for a preset number of times within the preset time period, controlling the corresponding heating device by the corresponding control device to follow the heating state of the heating device of the adjacent heated part to heat the heated part.

11. The pipeline temperature control method according to claim 2, wherein the step S4
comprises:
after heating the heated part for the preset time period, obtaining a current temperature of the heated part, and determining an absolute value of a difference between a target temperature of the heated part and the current temperature is less than a preset value, controlling the corresponding heating device by the corresponding control device of the heated part to maintain a constant temperature through heating.
